# EUROPEAN PATENT SPECIFICATION

(11) **EP 2 489 717 B1**
(45) Date of publication and mention of the grant of the patent: **10.10.2018**
(21) Application number: 12150092.0
(22) Date of filing: 03.01.2012
(51) Int. Cl.: C09K 11/77, H05B 33/14, H01J 61/42, H01L 31/055, H01L 33/50

(54) **Illumination device**
Beleuchtungsvorrichtung
Dispositif d'illumination

(30) Priority: 24.01.2011 JP 2011012374
(43) Date of publication of application: 22.08.2012
(73) Proprietor: Panasonic Electric Works Co., Ltd., Kadoma-shi Osaka 571-8686 (JP)
(72) Inventor: Toda, Naohiro, Osaka, Osaka (JP); Saito, Takashi, Hirakata, Osaka (JP); Noguchi, Hiroki, Sanda, Osaka (JP); Yamaguchi, Sayaka, Ibaraki, Osaka (JP)
(74) Representative: Rüger Abel

(56) References cited:
- US-A1- 2005 247 953
- US-A1- 2007 075 629
- US-A1- 2010 171 440
- US-B1- 6 580 097
- YE S ET AL: "Phosphors in phosphor-converted white light-emitting diodes: Recent advances in materials, techniques and properties", MATERIALS SCIENCE AND ENGINEERING R: REPORTS, ELSEVIER SEQUOIA S.A., LAUSANNE, CH, vol. 71, no. 1, 1 December 2010 (2010-12-01), pages 1-34, XP027524971, ISSN: 0927-796X [retrieved on 2010-08-06]

## Description

### [Field of the Invention]

The present invention relates to an illumination device.

### [Background Art]

Among illumination devices each provided with a light emitting part having an LED element, one that combines red, green, and blue LED elements respectively having different peak wavelengths to emit, for example, a white light is known (see, for example, JPA 2007-173557)

In the illumination device of JPA 2007-173557, by adjusting a combination of the peak wavelengths of the respective color LED elements, high color rendering property can be obtained, and also efficiency of suppressing melatonin generation can be controlled according to a situation.

US 2010/0171440 A1 shows an illumination device having light emitting parts that emit red, green and yellow light by means of combining an LED with a respective phosphor of the desired color. The LED emission wavelength can vary as long as is overlaps with the absorption wavelength of the phosphor. The colors of the light emitting parts are mixed to obtain a desired color, e.g. white light.

### [Disclosure of the Invention]

### [Problems to be solved by the Invention]

Meanwhile, the illumination device as described above is adapted to use LED elements respectively having three colors of red, green, and blue and different peak wavelengths to be able to control a degree of color rendering property and melatonin suppression efficiency. However, in the case of using the LED elements having the respective colors, a variation in color is large, and therefore it is necessary to select an LED element and adjust an individual control value for reducing the variation, so that it is desired to develop an illumination device that can efficiently obtain a desired spectral characteristic with a simple configuration.

The present invention is made in order to solve the above problem, and an object thereof is to provide an illumination device that can efficiently obtain a desired spectral characteristic with a simple configuration.

### [Means adapted to solve the Problems]

In order to solve the above problem, an illumination device of the present invention is provided with a light emitting part that has at least an LED element having a blue wavelength range, and a blue-green phosphor that has a peak wavelength in the range of 480 to 520 nm and a half bandwidth of 20 to 50 nm according to the features of claim 1.

In the above configuration the light emitting part is configured such that upon an emission power of the LED element having the blue wavelength range being assumed to be 1, an emission power of the blue-green phosphor at the peak wavelength is adjusted to be 04 or more and 1.2 or less.

In the above configuration the light emitting part is provided with: a first light emitting part that has at least an LED element having a blue wavelength range and a blue-green phosphor that has a peak wavelength in the range of 480 to 520 nm and a half bandwidth of 20 to 50 nm; and a second light emitting part that has larger x and y chromaticity values in an xy chromaticity diagram than the first light emitting part.

In the above configuration, preferably, the illumination device is further provided with a third light emitting part that has larger x and y chromaticity values in the xy chromaticity diagram than the first light emitting part.

In the above configuration, the second light emitting part is configured to emit at least white light.

In the above configuration, preferably, the illumination device is provided with adjustment means adapted to adjust an emission power of the light emitting part.

### [Effect of the Invention]

According to the present invention, an illumination device that can efficiently obtain a desired spectral characteristic with a simple configuration can be provided.

### [Brief Description of the Drawings]

[Fig. 1] Fig. 1 is a schematic block diagram of an illumination device in the present embodiment.
[Fig. 2] Fig. 2 is an explanatory diagram for explaining differences in effect between respective conditions A to D and first to third comparative examples.
[Fig. 3] Fig. 3 is a characteristic diagram illustrating spectral distributions of first and second light emitting parts of the illumination device.
[Fig. 4] Fig. 4 is a characteristic diagram for explaining xy chromaticity of the illumination device.
[Fig. 5] Fig. 5 is a spectral characteristic diagram in the illumination device under the condition A.
[Fig. 6] Fig. 6 is a spectral characteristic diagram in the illumination device under the condition B.
[Fig. 7] Fig. 7 is a spectral characteristic diagram in the illumination device under the condition C.
[Fig. 8] Fig. 8 is a spectral characteristic diagram in the illumination device under the condition D.
[Fig. 9] Fig. 9 is a schematic block diagram of an illumination device in another embodiment.
[Fig. 10] Fig. 10 is a spectral characteristic diagram in an illumination device of the first comparative example.
[Fig. 11] Fig. 11 is a spectral characteristic diagram in an illumination device of the second comparative example.
[Fig. 12] Fig. 12 is a spectral characteristic diagram in an illumination device of the third comparative example.

### [Best Mode for Carrying Out the Invention]

In the following, one embodiment that embodies the present invention is described along the drawings.

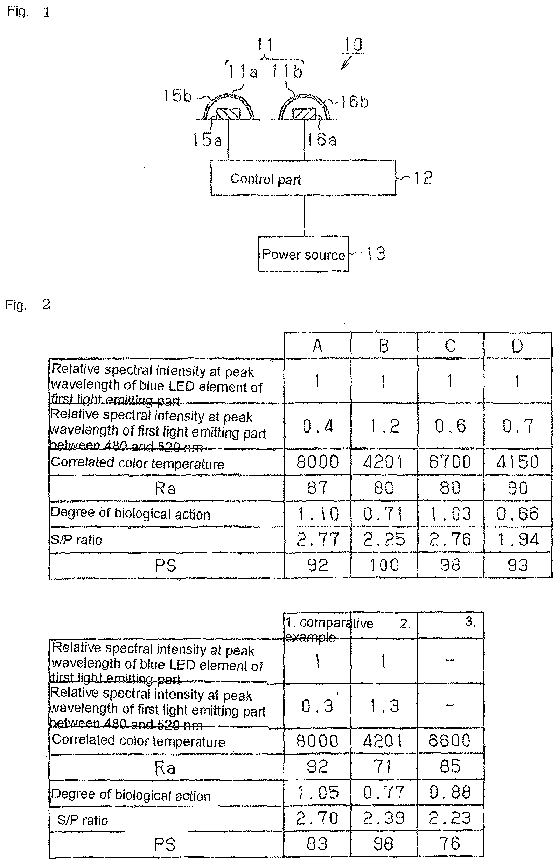

As illustrated in Fig. 1, an illumination device 10 of the present embodiment is provided with: a light emitting part 11; and a control part 12 that controls power supplied to the light emitting part 11 from a power source 13.

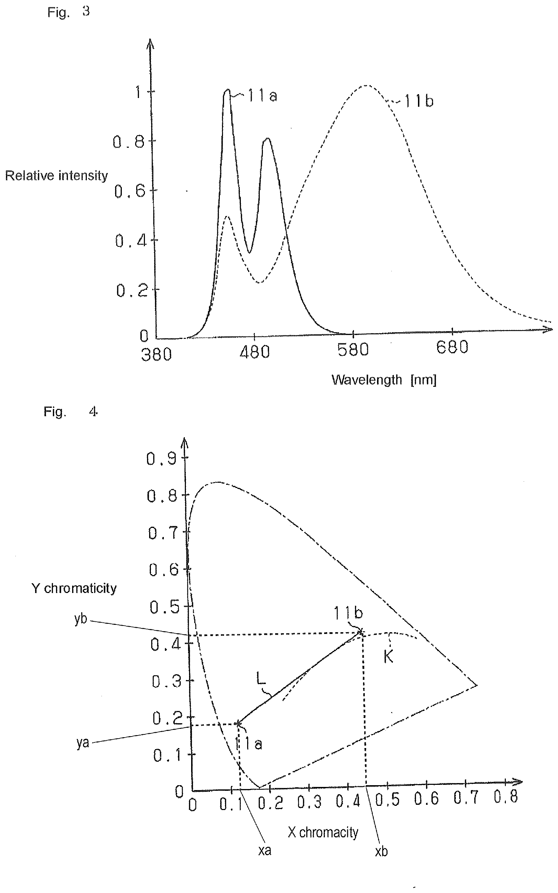

A first light emitting part 11a configuring the light emitting part 11 is configured to have a blue LED element 15a and a blue-green phosphor 15b that has a peak wavelength in the range of 480 to 520 nm and a half bandwidth of 20 to 50 nm. By employing such a configuration, for example, in the case of assuming that a relative intensity of the blue LED element 15a at its peak wavelength is 1, a spectral distribution characteristic as illustrated in Fig. 3 can be obtained. In addition, the blue-green phosphor 15b is a phosphor that is expressed by a general formula of M1-aSi202-1/2nXnN2:Eua, where preferably, M is at least one or more elements of strontium (Sr), barium (Ba), and calcium (Ca), X is at least one or more elements of chlorine (Cl) and bromine (Br), a meets 0.005 ≤ a ≤ 0.15, and n meets 0.02 ≤ n ≤ 0.2.

Also, a second light emitting part 11b configuring the light emitting part 11 is configured to have a blue LED element 16a and a phosphor 16b. The phosphor 16b configuring the second light emitting part 11b is configured to be any one of green, yellow, and red phosphors, or to combine a plurality of phosphors. On the basis of this, the second light emitting part 11b emits light color that has high x and y chromaticity values in the CIE 1931 xy chromaticity diagram illustrated in Fig. 4 as compared with the first light emitting part 11a. By employing such a configuration, in the case of assuming that a relative intensity of the phosphor 16b at its peak wavelength is 1, a spectral distribution characteristic as illustrated in Fig. 3 can be obtained.

In the illumination device 10 configured as described above, the control of the power from the power source 13 by the control part 12 enables each of the light emitting parts 11a and 11b to be lit or distinguished, or light from each of the light emitting parts 11a and 11b to be adjusted. Also, by adjusting light from each of the light emitting parts 11a and 11b by the control part 12, light color can be adjusted in a range along a straight line L in the CIE 1931 xy chromaticity diagram illustrated in Fig. 4. Also, as illustrated in Fig. 4, by setting a part of the straight line L to be superimposed on a black body radiation locus K, a color temperature can be adjusted in a range superimposed on the black body radiation locus K.

Next, a difference in each effect due to a difference in each condition of the illumination device 10 of the present embodiment is described with use of Figs. 2, 3, 5 to 8, and 10 to 12. In addition, in the present embodiment, the following (A) to (D), and (first comparative example) to (third comparative example) are conditioned.

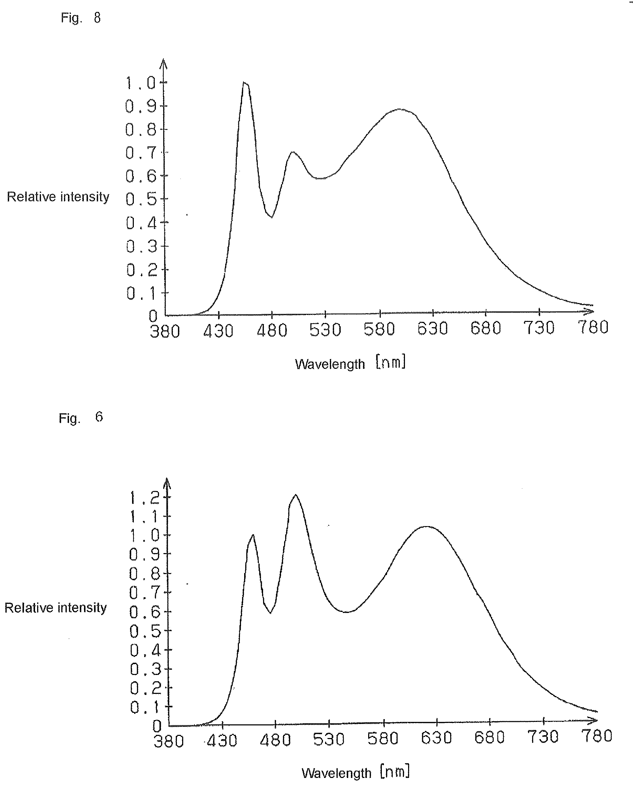

Condition (A): In the case of assuming that the relative spectral intensity of the blue LED element 15a of the first light emitting part 11a is 1, a relative spectral intensity at the peak wavelength in the wavelength range of 480 to 520 nm is adjusted to 0.4. Also, the respective light emitting parts 11a and 11b are controlled by the control part 12 to have a color temperature of approximately 8000 K. In addition, the spectral characteristic of the illumination device 10 configured in this manner are illustrated in Fig. 5.

Condition (B): In the case of assuming that the relative spectral intensity of the blue LED element 15a of the first light emitting part 11a is 1, the relative spectral intensity at the peak wavelength in the wavelength range of 480 to 520 nm is adjusted to 1.2. Also, the respective light emitting parts 11a and 11b are controlled by the control part 12 to have a color temperature of approximately 4201 K. In addition, the spectral characteristic of the illumination device 10 configured in this manner are illustrated in Fig. 6.

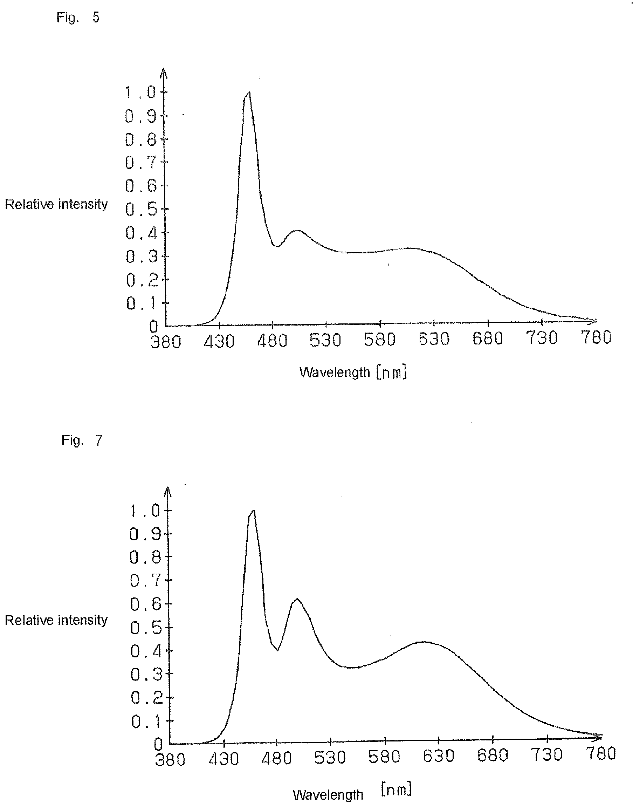

Condition (C): In the case of assuming that the relative spectral intensity of the blue LED element 15a of the first light emitting part 11a is 1, the relative spectral intensity at the peak wavelength in the wavelength range of 480 to 520 nm is adjusted to 0.6. Also, the respective light emitting parts 11a and 11b are controlled by the control part 12 to have a color temperature of approximately 6700 K. In addition, the spectral characteristic of the illumination device 10 configured in this manner are illustrated in Fig. 7.

Condition (D): In the case of assuming that the relative spectral intensity of the blue LED element 15a of the first light emitting part 11a is 1, the relative spectral intensity at the peak wavelength in the wavelength range of 480 to 520 nm is adjusted to 0.7. Also, the respective light emitting parts 11a and 11b are controlled by the control part 12 to have a color temperature of approximately 4150 K. In addition, the spectral characteristic of the illumination device 10 configured in this manner are illustrated in Fig. 8.

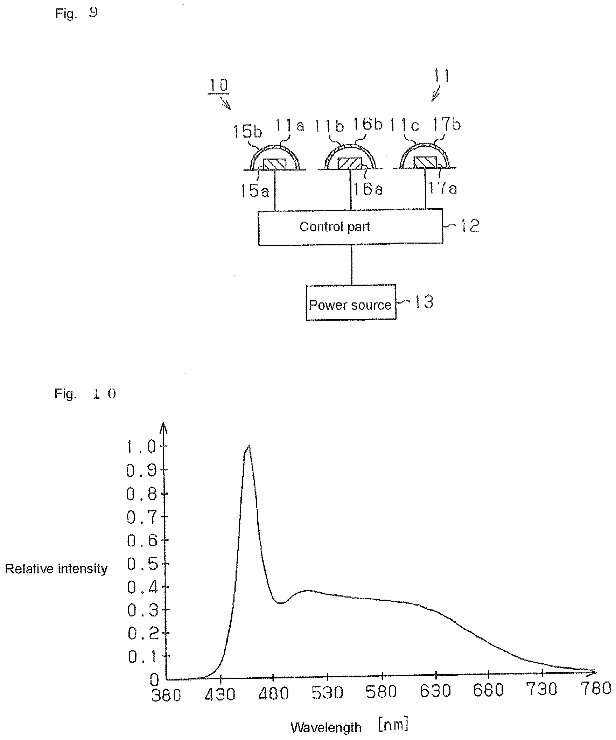

(First comparative example): In the case of assuming that the relative spectral intensity of the blue LED element 15a of the first light emitting part 11a is 1, the relative spectral intensity at the peak wavelength in the wavelength range of 480 to 520 nm is adjusted to 0.3. Also, the respective light emitting parts 11a and 11b are controlled by the control part 12 to have a color temperature of approximately 8000 K. In addition, spectral characteristic of an illumination device configured in this manner are illustrated in Fig. 10.

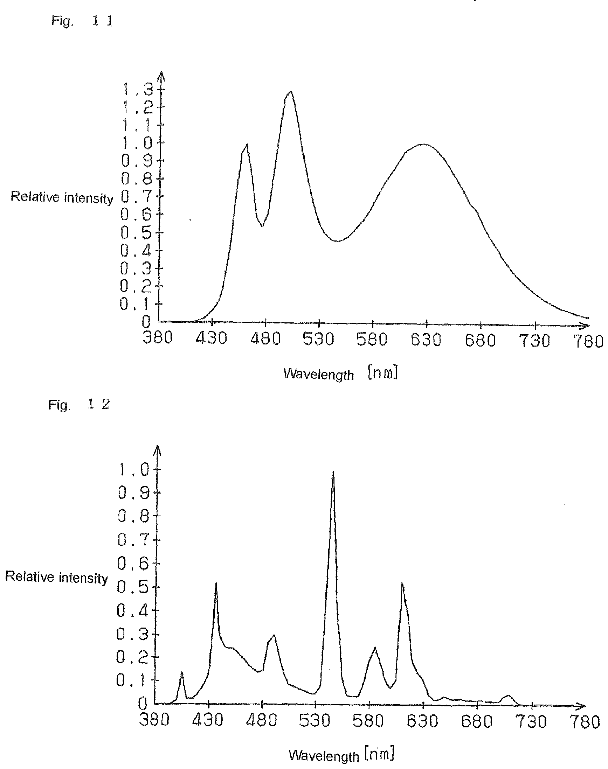

(Second comparative example): In the case of assuming that the relative spectral intensity of the blue LED element 15a of the first light emitting part 11a is 1, the relative spectral intensity at the peak wavelength in the wavelength range of 480 to 520 nm is adjusted to 1.3. Also, the respective light emitting parts 11a and 11b are controlled by the control part 12 to have a color temperature of approximately 4201 K that is the same as that of the condition C and substantially the same as that of the condition D. In addition, a spectral characteristic of an illumination device configured in this manner are illustrated in Fig. 11.

(Third comparative example): A three-wavelength fluorescent lamp having a color temperature of approximately 6600 K. In addition, a spectral characteristic of the illumination device configured in this manner are illustrated in Fig. 12.

### [Comparison between condition A and first comparative example]

For example, by configuring the respective light emitting parts 11a and 11b of the present embodiment according to the condition (A), a skin color favorable index PS of Japanese women can be adjusted to 92, and as compared with PS of 83 in the (first comparative example), a high value can be obtained. Also, the light emitting parts 11a and 11b configured according to the condition (A) enable an average color rendering index Ra to be adjusted to 80 or more, and therefore sufficient color rendering property can be obtained. Further, a degree of biological action that influences the suppression of melatonin secretion and a biological clock mechanism (circadian rhythm) can be adjusted to 1.1, and as compared with a degree of biological action of 1.05 in the (first comparative example), a high value can be obtained. Still further, an S/P ratio that is very effective under a mesopic environment can be adjusted to 2.77, so that the sufficient S/P ratio is obtained and therefore it is estimated that visibility under the mesopic environment is sufficiently ensured. Note that the S/P ratio refers to a ratio between a scotopic luminance value Ls calculated by multiplying a spectral visual efficiency V'(λ) in scotopic vision by a spectral characteristic of a lamp and a photopic luminance value Lp calculated by multiplying a spectral visual efficiency V(λ) in photopic vision by the spectral characteristic of the lamp.

### [Comparison between condition B and second comparative example]

Also, for example, by configuring the respective light emitting parts 11a and 11b of the present embodiment according to the condition (B), the skin color favorable index PS of Japanese women can be adjusted to 100, and as compared with PS of 98 in the (second comparative example), a high value can be obtained. Also, the light emitting parts 11a and 11b configured according to the condition (B) enable the average color rendering index Ra to be adjusted to 80 or more, and therefore as compared with Ra of 71 in the (second comparative example), sufficient color rendering property can be obtained.

### [Comparison between condition C and third comparative example]

Further, for example, by configuring the respective light emitting parts 11a and 11b of the present embodiment according to the condition (C), the skin color favorable index PS of Japanese women can be adjusted to 98, and as compared with PS of 76 in the (third comparative example), a high value can be obtained. Also, the light emitting parts 11a and 11b configured according to the condition (C) enable the average color rendering index Ra to be adjusted to 80, and therefore sufficient color rendering property can be obtained. Further, the degree of biological action that influences the suppression of melatonin secretion and the biological clock mechanism (circadian rhythm) can be adjusted to 1.03, and as compared with a degree of biological action of 0.88 in the (third comparative example), a high value can be obtained. Still further, the S/P ratio that is very effective under the mesopic environment can be adjusted to 2.76, so that the sufficient S/P ratio is obtained and therefore it is estimated that the visibility under the mesopic environment is sufficiently ensured.

### [Comparison between condition D and third comparative example]

Also, for example, by configuring the respective light emitting parts 11a and 11b of the present embodiment according to the condition (D), the skin color favorable index PS of Japanese women can be adjusted to 93, and as compared with PS of 76 in the (third comparative example), a high value can be obtained. Also, the light emitting parts 11a and 11b configured according to the condition (D) enable the average color rendering index Ra to be adjusted to 90, and therefore as compared with Ra of 85 in the (third comparative example), sufficient color rendering property can be obtained.

From the above-described comparison results, by configuring the first light emitting part 11a such that in the case of assuming that an emission power of the LED element 15a is 1, an emission power of the blue-green phosphor 15b at its peak wavelength is adjusted to be 04 or more and 1.2 or less, Ra and PS can be adjusted to 80 or more and 90 or more, respectively.

Next, characteristic effects of the present embodiment are described.
(1) The illumination device 10 is provided with the light emitting part 11a that has at least the LED element 15a having a blue wavelength range and the blue-green phosphor 15b that has the peak wavelength in the range of 480 to 520 nm and the half bandwidth of 20 to 50 nm. By employing such a configuration, light (light having a high degree of biological action) having a spectral distribution that strongly influences the suppression of melatonin secretion and the biological clock mechanism (circadian rhythm) can be achieved. Also, light having a spectral distribution (having a high PS) that enables skin appearance to be favorably showed can be achieved. Further, light having a spectral distribution (having a high S/P ratio) that improves visibility around a line of sight under the mesopic environment can be achieved. As described, such a simple configuration using the LED elements 15a and 16a having the same color enables a desired spectral characteristic to be efficiently obtained.
(2) The first light emitting part 11a is configured such that in the case of assuming that the emission power of the LED element 15a is 1, the emission power of the blue-green phosphor 15b at its peak wavelength is adjusted to be 04 or more and 1.2 or less. This enables the color rendering property to be high (Ra of 80 or more), and the PS value to be adjusted to 90 or more, and therefore light that, even under bluish white light having high color temperature or typical white light, causes object appearance to be faithfully viewed, and skin color (facial color) of a person to be favorably viewed can be achieved. Also, at particularly high color temperature, although Ra and PS are adjusted to 80 or more and 90 or more, respectively, the degree of biological action and S/P ratio can be simultaneously increased.
(3) The light emitting part 11 is provided with: the first light emitting part 11a that has at least the blue LED element 15a and the blue-green phosphor having the peak wavelength in the range of 480 to 520 nm and the half bandwidth of 20 to 50 nm; and the second light emitting part 11b that has the larger x and y chromaticity values in the xy chromaticity diagram than the first light emitting part 11a. By employing such a configuration, when the lights of the respective light emitting parts 11a and 11b are combined to mix colors, a white color having a target color temperature can be achieved.
(4) The illumination device 10 is provided with the control part 12 that adjusts an emission power of the first light emitting part 11a. As described, by adjusting the power of the first light emitting part 11a, control to achieve a highest illumination intensity and a lowest power at high color temperature and low color temperature, respectively, can be performed with a simple configuration.
(5) Also, an emission power of the second light emitting part 11b can be changed by the control part 12, and therefore a color temperature can be changed in a wider range.

Note that the embodiment of the present invention may be modified as follows:
The above embodiment is configured to use the two light emitting parts 11a and 11b; however, the present invention may employ a configuration that, for example, as illustrated in Fig. 9, uses three light emitting parts 11a to 11c. In addition, the third light emitting part 11c is configured to have a blue LED element 17a and a phosphor 17b. The phosphor 17b configuring the third light emitting part 11c is configured to be any one phosphor of green, yellow, and red phosphors, or to combine a plurality of phosphors. Also, preferably, the third light emitting part 11c has larger x and y chromaticity values in the xy chromaticity diagram than the first light emitting part 11a. By employing such a configuration, when lights of the respective light emitting parts 11a and 11b are combined to mix colors, a fine adjustment can be made to achieve a target color temperature.

Also, the present invention may employ a configuration that uses one light emitting part (first light emitting part 11a). Further, the present invention may employ a configuration that uses four or more light emitting parts.

Although in the above embodiment, not particularly referred to, the second light emitting part 11b may be configured to emit at least white light. By causing the second light emitting part 11b to correspond to the white light, even when the first light emitting part 11a is extinguished, white color can be kept. Because the first light emitting part 11a is extinguished, the degree of biological action is decreased and therefore light suitable for illumination during evening to night can be achieved.

Although in the above embodiment, not particularly referred to, the present illumination device 10 may be used as any of various illumination fixtures such as a base light, a downlight, a spotlight, a bracket light, a pendant light, and a ceiling light.

### [Description of Reference Numerals]

10: Illumination device
11: Light emitting part
11a: First light emitting part
11b: Second light emitting part
11c: Third light emitting part
12: Control part (adjustment means)
15a: LED element
15b: Blue-green phosphor

## Claims

1. An illumination device comprising a first light emitting part (11a) having a blue LED element (15a) emitting light in a blue wavelength range and having a blue-green phosphor (15b) that has a peak wavelength in a range of 480 to 520 nm, and a half bandwidth of 20 to 50 nm of the emitted light;
the illumination device further comprising a second light emitting part (11b);
wherein the first light emitting part (11a) emits light having x- and y-chromaticity values xa, ya in the CIE 1931 chromaticity diagram and the second light emitting part (11b) emits light having x- and y-chromaticity values xb, yb in the CIE 1931 chromaticity diagram, wherein the x-chromaticity value xb is larger than xa and the y-chromaticity value yb is larger than ya;
wherein the relative spectral intensity is the ratio of the of intensity of a first peak value through the intensity of a second peak value of the light emitted by the first and second light emitting parts (11a and 11b), wherein the first peak value is at the peak wavelength of the blue light emitted by the blue LED element (15a) of the first light emitting part (11a) and the second peak value in the wavelength range of 480 nm to 520 nm;
and wherein the relative spectral intensity is 1:0.4 or less and 1:1.2 or more.

2. The illumination device according to claim 1, wherein the second light emitting part (11b) has a blue LED element (16a) emitting light in a blue wavelength range and has at least one of a green, yellow and red phosphor (16b).

3. The illumination device according to claim 1, wherein the light color can be adjusted along a straight line L in the CIE 1931 chromaticity diagram between the point with the chromaticity values xa, ya of the first light emitting part (11a) and the point with the chromaticity values xb, yb of the second light emitting part (11b).

4. The illumination device according to claim 3, wherein a part of the straight line L is set to be superimposed on a black body radiation locus K.

5. The illumination device according to one of the preceding claims, wherein a third light emitting part (11c) is provided having a blue LED element (17a) and having at least one of a green, yellow and red phosphor (17b);
wherein the third light emitting part (11c) emits light having x- and y- chromaticity values in the CIE 1931 chromaticity diagram that are larger than the respective x- and y-chromaticity values xa and ya of the light of the first light emitting part (11a).

## Patentansprüche

1. Beleuchtungsvorrichtung aufweisend einen ersten Lichtemissionsteil (11a) mit einem blauen LED-Element (15a), das Licht in einem blauen Wellenlängenbereich emittiert und einen Blau-Grün-Phosphor (15b) aufweist, der einen Wellenlängenmaximalwert in einem Bereich von 480 bis 520 nm aufweist und eine halbe Bandbreite von 20 bis 50 nm des emittierten Lichts aufweist;
wobei die Beleuchtungsvorrichtung außerdem einen zweiten Lichtemissionsteil (11b) aufweist;
wobei der erste Lichtemissionsteil (11a) Licht emittiert, das x- und y-Chromatizitätswerte xa, ya in dem CIE-1931-Chromatizitätsdiagramm hat und der zweite Lichtemissionsteil (11b) Licht emittiert, das x- und y-Chromatizitätswerte xb, yb in dem CIE-1931-Chromatizitätsdiagramm hat, wobei der x-Chromatizitätswert xb größer ist als xa und der y-Chromatizitätswert yb größer ist als ya;
wobei die relative spektrale Intensität das Verhältnis der Intensität eines ersten Maximalwertes zu der Intensität eines zweiten Maximalwertes des Lichts ist, das durch den ersten und den zweiten Lichtemissionsteil (11a und 11b) emittiert wird, wobei der erste Maximalwert bei dem Wellenlängenmaximalwert des blauen Lichts liegt, das durch das blaue LED-Element (15a) des ersten Lichtemissionsteils (11a) emittiert wird und der zweite Maximalwert in dem Wellenlängenbereich von 480 nm bis 520 nm liegt;
und wobei die relative spektrale Intensität 1:0,4 oder weniger und 1:1,2 oder mehr ist.

2. Beleuchtungsvorrichtung nach Anspruch 1, wobei der zweite Lichtemissionsteil (11b) ein blaues LED-Element (16a) hat, das Licht in einem blauen Wellenlängenbereich emittiert und einen grünen und/oder gelben und/oder roten Phosphor (16b) aufweist.

3. Beleuchtungsvorrichtung nach Anspruch 1, wobei die Lichtfarbe entlang einer geraden Linie L zwischen dem Punkt mit den Chromatizitätswerten xa, ya des ersten Lichtemissionsteils (11a) und dem Punkt mit den Chromatizitätswerten xb, yb des zweiten Lichtemissionsteils (11b) in dem CIE-1931-Chromatizitätsdiagramm eingestellt werden kann.

4. Beleuchtungsvorrichtung nach Anspruch 3, wobei ein Teil der geraden Linie L vorgegeben ist, um mit einer Kurve K der Schwarzkörperstrahlung überlagert zu werden.

5. Beleuchtungsvorrichtung nach einem der vorhergehenden Ansprüche, wobei ein dritter Lichtemissionsteil (11c) bereitgestellt ist mit einem blauen LED-Element (17a) und mit einem grünen und/oder gelben und/oder roten Phosphor (17b);
wobei der dritte Lichtemissionsteil (11c) Licht emittiert mit x- und y-Chromatizitätswerten in dem CIE-1931-Chromatizitätsdiagramm, die größer sind als die jeweiligen x- und y-Chromatizitätswerte xa und ya des Lichts des ersten Lichtemissionsteils (11a).

## Revendications

1. Dispositif d'éclairage comprenant une première partie émettrice de lumière (11a) comportant un élément formant DEL bleue (15a) émettant de la lumière dans une gamme de longueur d'onde bleue et ayant une substance luminescente bleu-vert (15b) qui a un pic de longueur d'onde dans une plage de 480 à 520 nm, et une demie largeur de bande de 20 à 50 nm de la lumière émise ;
le dispositif d'éclairage comprenant en outre une deuxième partie émettrice de lumière (11b);
dans lequel la première partie émettrice de lumière (11a) émet une lumière ayant des valeurs de chromaticité x et y xa, ya dans le diagramme de chromaticité CIE 1931 et la deuxième partie émettrice de lumière (11b) émet une lumière ayant des valeurs de chromaticité x et y xb, yb dans le diagramme de chromaticité CIE 1931, dans lequel la valeur de chromaticité x xb est supérieure à xa et la valeur de chromaticité y yb est supérieure à ya ;
dans lequel l'intensité spectrale relative est le rapport de l'intensité d'une première valeur de pic sur l'intensité d'une deuxième valeur de pic de la lumière émise par les première et deuxième parties émettrices de lumière (11a et 11b), dans lequel la première valeur de pic est à la longueur d'onde de pic de la lumière bleue émise par l'élément formant DEL bleue (15a) de la première partie émettrice de lumière (11a) et la deuxième valeur de pic dans la plage de longueur d'onde de 480 nm à 520 nm ;
et dans lequel l'intensité spectrale relative est inférieure ou égale à 1/0,4 et supérieure ou égale à 1/1,2.

2. Dispositif d'éclairage selon la revendication 1, dans lequel la deuxième partie émettrice de lumière (11b) comporte un élément formant DEL bleue (16a) émettant de la lumière dans une gamme de longueur d'onde bleue et comporte au moins un élément parmi une substance luminescente verte, jaune et rouge (16b).

3. Dispositif d'éclairage selon la revendication 1, dans lequel la couleur de la lumière peut être réglée le long d'une ligne droite L dans le diagramme de chromaticité CIE 1931 entre le point ayant les valeurs de chromaticité xa, ya de la première partie émettrice de lumière (11a) et le point ayant les valeurs de chromaticité xb, yb de la deuxième partie émettrice de lumière (11b).

4. Dispositif d'éclairage selon la revendication 3, dans lequel une partie de la droite L est prévue pour être superposée sur un lieu de rayonnement de corps noir K.

5. Dispositif d'éclairage selon l'une des revendications précédentes, dans lequel une troisième partie émettrice de lumière (11c) est prévue, ayant un élément formant DEL bleue (17a) et comportant au moins un élément parmi une substance luminescente verte, jaune et rouge (17b) ;
dans lequel la troisième partie émettrice de lumière (11c) émet une lumière ayant des valeurs de chromaticité x et y dans le diagramme de chromaticité CIE 1931 qui sont plus grandes que les valeurs de chromaticité x et y respectives xa et ya de la lumière de la première partie émettrice de lumière (11a).
